# EUROPEAN PATENT APPLICATION

(11) **EP 0 548 980 A1**
(43) Date of publication of application: **30.06.1993**
(21) Application number: 92121960.6
(22) Date of filing: 23.12.1992
(51) Int. Cl.: G02F 1/37, B29D 11/00

(54) **Frequency conversion device and process for producing the same**

(30) Priority: 24.12.1991 JP 341143/91
(71) Applicant: HOECHST AKTIENGESELLSCHAFT, D-65926 Frankfurt am Main (DE)
(72) Inventor: Johnson, Robert, Dr., Kawagoe-shi, Saitam (JP)

(57) **Abstract**

The fiber type frequency conversion element of the present invention is composed of a core comprising an organic nonlinear optical material (3) and a clad comprising polymeric organic material (1). The organic nonlinear optical material preferably has a melting point of from 70 to 200°C, and the high polymeric organic material has a melting point which is higher than that of the nonlinear optical material by at least 20°C.

## Description

### Field of the Invention

This invention relates to a frequency conversion device for use in the field of information processing or instrumentation control utilizing laser light.

### Prior Art

In recent years, materials with nonlinear optical effects and devices making use of their nonlinear optical effects have been subjected to detailed studies.

Nonlinear optical effects are optical effects manifested by nonlinearity resulting from a phenomenon that electric field-induced polarization in the inside of a crystal has second and the higher terms. Such second nonlinear optical effects include, for example, second-harmonic generation (SHG) and optical modulation. These second nonlinear optical effects are applicable to the field of information processing and instrumentation control utilizing opto-electronics in the form of nonlinear optical devices, such as frequency convertors and optical modulators.

For example, SHG devices are made up of nonlinear optical materials to generated second-harmonic having a angular frequency 2ω from the nonlinear polarization induced by the fundamental wave at angular frequency ω. SHG devices are roughly divided into a bulk form using a bulk nonlinear optical crystal and a waveguiding form having a waveguide. Considering the latest frequent use of laser diode light as a light source and capability of highly efficient second-harmonic generation, a SHG device of waveguide geometry is more advantageous.

Waveguide structures include a ridge structure composed of a base made of a nonlinear optical material having formed thereon a ridge and a fiber structure composed of a core made of a nonlinear optical material and a clad made of an appropriate cladding material. Of these structures, the fiber structure has advantages such as suitability to small-sized devices and capability of generating a second-harmonic having a highly symmetric beam form.

Included in known SHG devices of fiber structure is a wavelength conversion device composed of a nonlinear optical. (NLO) material exhibiting nonlinear optical effects, such as inorganic materials, e.g., KDP (KH₂PO₄) and LiNbO₃, as a core and a glass clad. Such a fiber type wavelength conversion device is disclosed, e.g., in Japanese Patent Application Laid-Open No. 185838/88.

In recent years, many studies have been conducted on organic materials having large nonlinear optical hyperpolarizabilities and comprising a core of fiber type wavelength conversion devices employed for frequency conversion of laser diode light.

### Object of the Invention

However, it has been difficult to consistently produce a high quality fiber type SHG device from an organic material core and a glass clad. In particular, difficulties from the incorporation of impurities forming between a core and clad and of void formation have been encountered.

In view of the above-mentioned disadvantages of the conventional techniques, an object of the present invention is to provide a novel fiber type frequency conversion device and a process for producing the same while eliminating these disadvantages.

### Means for Accomplishing the Object

To settle the above-described problems, a Cherenkov radiation SHG device is used in the present invention.

A Cherenkov radiation SHG device is advantageous over other SHG devices for the following reasons.
1) Because the fundamental and second-harmonic light waves do not need to be phase matched, designing the waveguide is relatively easy.
2) The SHG material used in a Cherenkov radiation SHG device does not require transparency for generated second-harmonic as do other waveguiding geometries; and, fundamental power density values can be kept higher over the interaction length.
3) The largest nonlinear optical coefficients of the SHG materials as well as those resulting from the diagonal tensorial devices not accessible in bulk phase matching can be fully utilized in frequency conversion .
4) The typical Cherenkov radiation SHG device geometry requires protection of the SHG material with clad. Although organic materials have poor mechanical strength, this design provides some mechanical protection.

The frequency conversion device according to the present invention will hereinafter be described in detail.

As stated above, the frequency conversion device of the present invention is a fiber type device composed of an organic NLO core and the surrounding organic polymer clad. Since the organic polymeric clad material has a thermal expansion coefficient similar to the organic NLO core material, the cooling and resultant crystallization will not exhibit the catastrophic stress buildup often observed when a glass capillary is used for clad.

In conventional fiber type SHG devices employing a glass capillary as a clad, designs for the chemical structure of the glass involved have failed to induce molecular interactions between the glass and the organic NLO material so as to optimize orientation of the organic NLO molecules. It has now been found that use of polymeric organic materials in place of glass makes it possible to control the crystal nature of the organic NLO material. In other words, the molecular interactions between the organic polymeric clad material and the organic NLO core material are fully exploited while utilizing the great variety of chemical characteristics possessed by the polymeric organic materials and resulting from their surface chemical modifications. Such interactions nclude hydrogen bonding, van der Waals force, and dipole interaction. These interactions optimize orientation of the organic NLO core molecules and improve the Cherenkov radiation second-harmonic generation efficiency to the highest possible value. This is based on the fact that the crystalline nature of organic NLO materials, i.e., molecular packing of the core is of the highest importance to the SHG efficiency.

Thus, proper selection of an organic NLO core material and a polymeric organic clad material enables the nonlinear optical axis of the fiber to have optimum orientation for Cherenkov type SHG devices with influences of the high polymeric organic material upon crystal characteristics of the organic NLO material being taken advantage of.

Further, sheathing the core with the high polymeric organic material endows the core with not only mechanical strength but also higher flexibility as compared with the glass clad. Use of the organic substance also holds an advantage in that the resulting fiber is lighter than the glass cladding fiber.

The organic NLO core material which can be used in the frequency conversion device of the present invention should have a higher refractive index than that of the polymeric organic clad material. As hereinafter described, because the frequency conversion device of the invention can be fabricated in a bicomponent spinning step, it is offered as a filament of substantially unlimited length.

In the present invention, various substances can be used as core material 3. Core material 3 comprises an organic NLO material as described. The organic NLO material to be used in the present invention is a substance which is fluid at the time of fiber production (i.e., at the time of melt spinning) and crystallizes upon cooling to room temperature. In a preferred embodiment of the present invention, the organic NLO material has a melting point of from 70 to 200°C. Examples of such useful organic NLO materials are 2-methyl-4-nitroaniline (MNA), 3-nitroaniline (m-NA), 3,5-dinitrobenzene, 2-bromo-4-nitroaniline, 3-methyl-4-nitropyridine-N-oxide (POM), 2-dimethylamino-5-nitroacetanilide (DAN), 2-methoxy-5-nitrophenol (MNP), and 3,5-dimethyl-1-(4-nitrophenyl)pyrazole (DMNP). In a particularly preferred embodiment, 2-methyl-4-nitroaniline is used as core material 3.

On the other hand, a variety of organic high polymeric materials can be used as cladding material 1. It is noted, however, that the polymeric organic material as cladding material 1 preferably has a higher melting point than that of the organic NLO material as core material 3. In a preferred embodiment of the present invention, cladding material 1 has a melting point higher than that of core material 3 by at least 20°C. However, if cladding material 1 has a higher melting point which is too high in relation to that of the core material, an extremely high spinning temperatures would be required, possibly resulting in impairment of stability of core material 3. Accordingly, it is desirable for the melting point of cladding material 1 to fall within such a range that allows core material 3 to remain in a thermally stable state. In another preferred embodiment, cladding material 1 to be used includes poly-(ethylenetetrafluoroethylene), polycarbonates, polyesters, polyamides, polyolefins, and polyacrylates. In a particularly preferred embodiment, poly(ethylenetetrafluoroethylene) is used as cladding material 1.

The process for producing the frequency conversion device according to the present invention is described below. A bicomponent clad/core spinning process is employed in the present invention. This process is similar to the so-called pipe-in-pipe process frequently used for mixed stream formation.

According to the pipe-in-pipe process, the frequency conversion device of the present invention can be continuously produced, and both clad and core are simultaneously fabricated through one step. That is, the production line is simplified, affording advantages in time and cost. In addition, as compared with the conventional technique comprising vacuum filling a glass capillary with a molten NLO material, this process is less likely to result in void formation or the occurrence impurities in the core, thus providing frequency conversion elements of excellent quality.

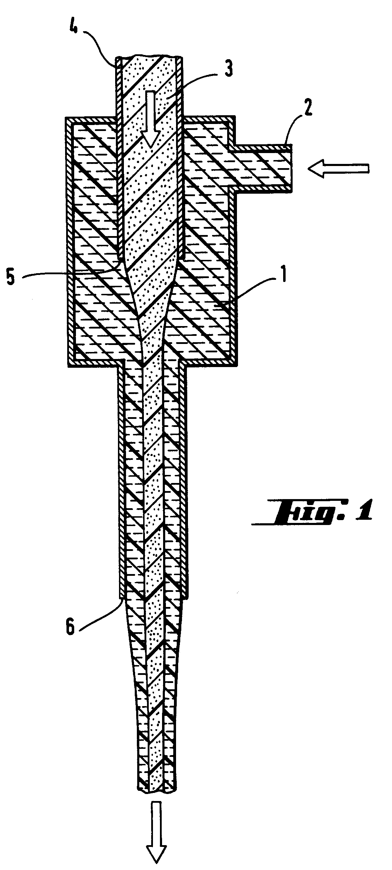

Fig. 1 shows a pipe-in-pipe bicomponent spinning apparatus. An organic high polymeric material as cladding material 1 is fed through clad inlet 2, while an organic NLO material as core material 3 is fed through core inlet 4, both in a molten state. The two materials are previously heated and kneaded in separate extruders prior to feeding to the spinning apparatus. The extruders to be used are not particularly limited, and generally employed single-screw or twin-screw extruders may be used.

Both molten materials meet at orifice 5 and, without being mixed together, move in the spinning apparatus with the extruded stream of molten cladding material 1 (organic high polymeric material) concentrically sheathing the extruded stream of molten core material (organic NLO material), i.e., while maintaining a core/clad structure. The molten bicomponent stream is then spun from spinning die 6. The spun molten fiber is cooled by being passed through an appropriate fluid, e.g., air and water, and is then taken up. A cooling rate for the fluid is appropriately selected depending on the spinning conditions. If necessary, where the spun fiber is cooled in air, a chimney can be provided by the side of the running fiber so that low temperature cooling air may be applied to the fiber from a direction perpendicular to the fiber running direction for forced cooling.

Meanwhile, both materials constituting the fiber (i.e., organic NLO material and polymeric organic material) undergo several hundred-fold drawing. Perfect maintenance of the core/clad structure of the spun filament during the drawing relies on the nature of both materials and the core/clad interface stability.

The degree of crystallization of core material 3 can be controlled by adjusting the output of each material from the respective extruder, the take-up speed and the draw-down ratio of the spun fiber. Namely, by appropriate control of these conditions, an organic NLO core having a non-scattering and single domain can be formed.

The fiber diameter can be broadly controlled by proper selection of the spinning conditions. In a preferred embodiment of the present invention, a spun fiber has a core diameter of 5 µm and a clad thickness of 20 µm.

While the spinning apparatus shown in Fig. 1 has a single spinning die, a spinning apparatus equipped with a plurality of spinning dies may be used, if desired, to obtain a multi-filament fiber.

If desired, the organic NLO material after spinning can be subjected to a post treatment for obtaining high optical quality for the purpose of preventing scattering of transmitted light. In this case, the fiber is forwarded into a furnace kept at a temperature higher than the melting point of the core to melt the core and then slowly taken out of the furnace to the outside where the molten core is crystallized to enable the crystal to grow.

In this post treatment, the spun fiber, while being held straight, is subjected to a zone melt refining process in which the fiber slowly moves in a hot zone which is also held straight. The moving speed preferably ranges from 1 mm/hr to 100 mm/hr, though varying depending on the kind of the organic NLO material used. The temperature of the hot zone is preferagbly higher than the melting point of the organic NLO material and lower than the melting point of the polymeric organic material. The difference between the hot zone temperature and the melting point of the organic NLO material is dependent on the kind of the organic NLO material used but is 1 to 10°C higher than the melting point of core material 3.

Thus, the spun bicomponent fiber slowly moves in a single stage or multi-stage hot zone thereby making the organic NLO crystal a monodomain of high optical quality.

The process for producing the frequency conversion device according to the present invention is now illustrated in greater detail by way of Examples.

### EXAMPLE

A fiber type frequency conversion device was produced by the use of the pipe-in-pipe bicomponent spinning apparatus shown in Fig. 1. Poly(ethylenetetrafluoroethylene) and 2-methyl-4-nitroanilino (MNA) were used as cladding material 1 and core material 3, respectively.

Poly(ethylenetetrafluoroethylene) was heat-kneaded in an extruder at 200°C in a nitrogen atmosphere, and the molten material was fed in to the spinning apparatus through core inlet 2. Simultaneously, MNA was heat-kneaded in a separate extruder at 200°C in a nitrogen atmosphere and fed into the spinning apparatus through core inlet 4.

The molten fiber extruded from the spinning die was passed through air at room temperature while maintaining the core/clad structure and cooled and solidified, and then taken up by a take-up equipped with a traversing gear. The resulting fiber for frequency conversion element had a core diameter of 5 µm and a clad thickness of 20 µm. No void was observed in the core/clad interface.

### Effect of the Invention

As described above, the fiber type frequency conversion element according to the present invention is composed of a core and a clad both comprising organic materials. Since a small difference in thermal expansion coefficient exists between the two materials, there is observed neither cracking nor cleavage due to a difference between the thermal expansion coefficient of the clad and core.

### Brief Explanation of the Drawing

Fig. 1 illustrates a pipe-in-pipe bicomponent spinning apparatus. In the Figure, numerals 1 through 6 indicate cladding material, clad inlet, core material, core inlet, orifice, and spinning die, respectively.

## Claims

1. A fiber type frequency conversion device composed of a core comprising an organic nonlinear optical material and a clad comprising a polymeric organic material.

2. The frequency conversion device as claimed in Claim 1, wherein said organic nonlinear optical material has a melting point between 70° and 200°C.

3. The frequency conversion device as claimed in Claim 1, wherein said polymeric organic material has a melting point higher than that of the organic nonlinear optical material by at least 20°C.

4. A process for producing a fiber type frequency conversion device composed of a core comprising an organic non linear optical material and a clad comprising a polymeric organic material, which comprises concentrically sheathing the extruded stream of said molten organic nonlinear optical material with the extruded molten high polymeric organic material and simultaneously spinning the molten nonlinear organic optical material and the molten polymeric organic material from the same spinerette opening.

5. The process as claimed in Claim 4, wherein said process further comprises subjecting the spun fiber to zone melt refining.

6. The process as claimed in Claim 5, wherein temperature of the hot zone is 1 to 10°C higher than the melting point of the organic nonlinear optical material.
